Europäisches Patentamt

European Patent Office

Office européen des brevets

(11) Veröffentlichungsnummer: **0 045 113**
**B1**

(12) # EUROPÄISCHE PATENTSCHRIFT

(45) Veröffentlichungstag der Patentschrift:
**13.02.85**

(51) Int. Cl.⁴: **G 01 R 31/08, H 02 H 7/26**

(21) Anmeldenummer: **81200844.9**

(22) Anmeldetag: **23.07.81**

(54) **Verfahren und Anordnung zur Lokalisierung eines Erdschlusses.**

(30) Priorität: **30.07.80 DE 3028787**

(43) Veröffentlichungstag der Anmeldung:
**03.02.82 Patentblatt 82/5**

(45) Bekanntmachung des Hinweises auf die Patenterteilung:
**13.02.85 Patentblatt 85/7**

(84) Benannte Vertragsstaaten:
**AT CH DE LI NL**

(56) Entgegenhaltungen:
**ETZ-A, Band 95, Nr. 8, 1974, W. BAYH "Ein Erdschluss-Selektivschutz für vermaschte Mittelspannungsnetze", Seiten 416 bis 418
ETZ-A, Band 94, Nr. 4, 1973, R. FOERST "Methoden zur dynamischen Sicherheitsüberwachung elektrischer Netze", Seiten 216 bis 220
Elektrizitätswirtschaft, Jahrgang 76, 1977, H. 8, S. 202 bis 206**

**Die Akte enthält technische Angaben, die nach dem Eingang der Anmeldung eingereicht wurden und die nicht in dieser Patentschrift enthalten sind.**

(73) Patentinhaber: **BBC Aktiengesellschaft Brown, Boveri & Cie., Haselstrasse, CH-5401 Baden (CH)**

(72) Erfinder: **Hecht, Siegfried, Angelweg 30, D-6900 Heidelberg (DE)**

## Beschreibung

Bei der Erfindung wird ausgegangen von einem Verfahren zur Lokalisierung eines einpoligen Erdschlusses in einem vermaschten, erdschlußkompensierten Drehstromnetz nach dem Oberbegriff des Patentanspruchs 1. Die Erfindung betrifft auch eine Erdschlußrelaisschaltung nach dem Oberbegriff des Patentanspruchs 4.

Die Erfindung geht aus von Verfahren zur Lokalisierung eines Erdschlusses, wie sie in der deutschen Zeitschrift »Elektrizitätswirtschaft«, Jahrgang 76 (1977), H. 8, S. 202—206, beschrieben sind. Dort ist der Sternpunkt einer Transformatorwicklung über eine Erdschlußlöschspule geerdet. Die Erdschlußspuleneinstellung wird durch Zu- und Abschalten eines Kondensators im Rhythmus von etwa 0,3 Hz verstimmt und damit eine rhythmische Änderung der Summenströme in den Leitungen zur Fehlerstelle bewirkt. Die Fehlerortung erfolgt durch eine Auswertung der Summenströme. Die Stromrichtung resultiert aus einer Netznachbildung. Vorwiegend zur Erfassung kurzzeitiger Erdschlüsse und zur Vorortung in Maschen oder Ringnetzen werden Erdschlußwischerrelais eingesetzt, zur Ortung von Dauererdschlüssen in Netzen mit induktiver Erdung Erdschlußortungsrelais.

In elektrischen Energieversorgungs-Drehstromnetzen mit induktiv über eine Erdschlußlöschspule geerdetem Nullpunkt haben einpolige Erdschlüsse lediglich eine Spannungsverlagerung des Nullpunktes zur Folge, d. h., der Betrieb wird nicht unterbrochen. Der Nullpunkt des Drehstromsystems wandert aus dem Mittelpunkt des gleichseitigen Spannungsdreiecks heraus in Richtung auf den Eckpunkt der erdschlußbehafteten Phase, d. h., der Nullpunkt nimmt Potential gegen Erde an, und bei den beiden anderen, nicht erdschlußbehafteten Phasen tritt eine Spannungserhöhung gegen Erde ein. Dadurch tritt zu dem symmetrischen 3-Phasensystem ein sogenanntes Nullsystem hinzu, dessen Quelle im Fußpunkt des Erdschlusses gedacht werden kann.

Dieses Nullsystem beaufschlagt einen Parallelschwingkreis, der in dem galvanisch verbundenen, erdschlußbehafteten Netz von der an einem Nullpunkt des Netzes gegen Erde geschalteten Erdschlußlöschspule und der Leiter-Erd-Kapazität der beiden nicht erdschlußbehafteten Phasenleiter des Netzes gebildet wird. Bei richtiger Resonanzabstimmung des so gebildeten Parallelschwingkreises auf die Netzfrequenz durch entsprechende Einstellung der Spuleninduktivität der Erdschlußlöschspule wird im Fußpunkt des Erdschlusses der induktive Spulenstrom von dem kapazitiven Leiter-Erd-Strom gerade kompensiert, und es fließt über die Fehlerstelle gerade noch der sogenannte Erdschluß-Reststrom (= Wattreststrom), ein Wirkstrom, der seine Ursache in der Dämpfung des Schwingkreises hat, in der Hauptsache von dem ohmschen Verlustwiderstand der Spule herrührt, nur zu einem geringen Teil vom ohmschen Ableitungswiderstand herrührt und nur einen Bruchteil des induktiven Spulenstroms bzw. des kapazitiven Ableitungsstroms beträgt.

Die Flußrichtung der so über die Fehlerstelle fließenden Erdschluß-Wirkleistung, d. h., des Produktes aus der Verlagerungsspannung (der Spannung des Nullsystems) und dem ohmschen Erdschluß-Reststrom (Wattreststrom), kann in allen Punkten des erdschlußbehafteten Netzes z. B. am Zeigerausschlag eines Wattmeters festgestellt werden, wobei die Verlagerungsspannung z. B. an drei sekundärseitig im offenen Dreieck geschalteten Einphasenspannungswandlern erhalten werden kann, die primärseitig in Stern geschaltet sind, und der Summenstrom, der den Wattreststrom als Komponente enthält, über einen Summenstromwandler erhalten wird.

Die Flußrichtung der Erdschluß-Wirkleistung zeigt somit von allen Punkten des Netzes auf die Fehlerstelle. Eine andere Möglichkeit, den Erdschluß zu orten, besteht darin, die Richtung der bei Eintritt des Erdschlusses anfallenden Umlade-Energie der Leiter-Erd-Kapazitäten zu messen.

Die an allen Punkten des Netzes feststellbare Erdschluß-Reststrom-Energierichtung beschreibt somit ein Vektorfeld, dessen Quelle der Fußpunkt des Erdschlusses ist. An allen Netzknoten (Sammelschienen) muß dabei die Divergenz gleich Null sein, und nur für die erdschlußbehaftete Masche (Leitung) ist sie ungleich Null (ein erdschlußbehafteter Knoten ist in der Praxis sehr selten).

Theoretisch wäre es somit bei entsprechendem Aufwand einfach, den Erdschluß zu lokalisieren. Zur Energierichtungsbestimmung gibt es wattmetrische· Erdschlußrichtungsrelais und/ oder Erdschluß-Wischerrelais, die überall im Netz eingebaut werden können. Jedoch ist die Empfindlichkeit dieser Geräte begrenzt bzw. sie ist absichtlich verringert, damit Wandlerfehler keine Fehlanzeigen hervorrufen können. Ferner können solche Geräte aus Kostengründen nur in einigen Hauptknoten des oft vermaschten Netzes installiert werden.

In vermaschten Netzen teilt sich des weiteren der Energiefluß des Erdschluß-Reststroms immer mehr auf, je weiter der Fußpunkt des Erdschlusses entfernt ist. Dies wirkt sich dadurch aus, daß nur ein Teil der Geräte anspricht und eine Ermittlung des Erdschlusses aus den verbleibenden Richtungsanzeigen schwierig bzw. unmöglich ist.

In der Praxis ist es dann nötig, das Netz an mehreren Stellen aufzutrennen und festzustellen, in welchem Netzteil der Erdschluß verbleibt (d. h., die Spannungsverlagerung bestehen bleibt), um die Fehlerstelle einzukreisen. Das erfordert Schaltungsmaßnahmen, die zum einen die Gefahr von Schalt-Überspannungen und damit von Doppelfehlern mit sich bringen und zum anderen teilweise für den Stromabnehmer störende Abschaltungen verursachen.

Die Erfindung, wie sie in den Patentansprüchen 1 und 4 definiert ist, löst die Aufgabe, ein Verfahren und eine Erdschlußrelaisschaltung zur Lokalisierung eines einpoligen Erdschlusses in einem vermaschten, gelöschten, d. h. erdschlußkompensierten Drehstromnetz mit induktiv über eine Erdschlußlöschspule geerdetem Nullpunkt anzugeben, die eine schnelle, sichere und für die Stromabnehmer nicht störende Auffindung des Erdschlußfußpunktes ermöglichen, wobei die Richtung des fließenden Erdschluß-Reststroms mit Hilfe von im Netz eingebauten Relais feststellbar sein soll.

Die mit der Erfindung erzielbaren Vorteile bestehen insbesondere darin, daß die Lokalisierung eines Erdschlusses wesentlich erleichtert wird und auch bei stark vermaschten Netzen eine rasche Auffindung des Fußpunktes des Erdschlusses ermöglicht wird.

Zum einschlägigen Stand der Technik wird zusätzlich auf die deutsche Zeitschrift »ETZ-A«, Bd. 95 (1974), H. 8, S. 416—418, verwiesen, aus der es bekannt ist, die Verhältnisse in einem erdschlußbehafteten, vermaschten Mittelspannungsnetz durch einen im Fehlerort eingeführten Stromgenerator darzustellen, welcher einen Strom in Größe des Erdschlußstroms in das Netz einprägt. Ein Netzsimulationsmodell ist nicht offenbart.

Aus der Zeitschrift »ETZ-A«, Bd. 94 (1973), H. 4, S. 216—220, ist es bekannt, bei einem elektrischen Netz durch Simulationsmodelle Erkenntnisse über dessen Eigenschaften zu gewinnen. Mittels Rechnern kann die Netzstabilität unter Zugrundelegung detaillierter Nachbildungen des Netzes berechnet werden. Eine Nachbildung der Leitungswiderstände und der Erdschlußlöschspule durch ohmsche Widerstände ist nicht offenbart.

Ein Ausführungsbeispiel der Erfindung ist im folgenden anhand der Zeichnungen erläutert. Es zeigt

Fig. 1 ein Drehstromnetz mit Erdschlußlöschspule bei einpoligem Erdschluß,

Fig. 2 ein Ersatzschaltbild des Nullsystems,

Fig. 3 ein einpoliges Gleichstromsimulationsmodell für simulierte Erdschlußrichtungsanzeigen in einem vermaschten gelöschten Netz.

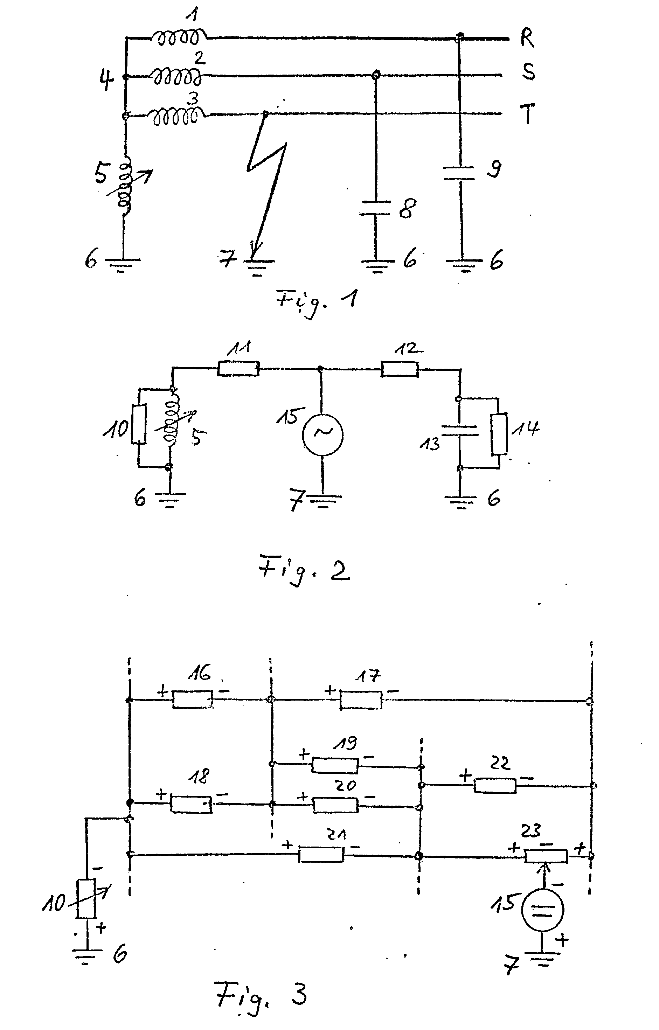

In Fig. 1 ist ein Drehstromnetz mit Erdschlußlöschspule bei einpoligem Erdschluß dargestellt. Mit Bezugsziffern 1, 2, 3 sind Transformatorwicklungen bezeichnet, die mit den Phasenleitern R, S, T eines Drehstromnetzes verbunden sind. Die Transformatorwicklungen 1, 2, 3 sind sternförmig verbunden und bilden einen gemeinsamen Nullpunkt 4, der über eine einstellbare Erdschlußlöschspule 5 an Erde 6 liegt. Mit der Bezugsziffer 7 ist der Fußpunkt eines Erdschlusses im Phasenleiter T bezeichnet. Des weiteren sind in Fig. 1 die Leiter-Erd-Kapazität 8 der Phase S und die Leiter-Erd-Kapazität 9 der Phase R dargestellt.

Durch den Erdschluß im Phasenleiter T tritt, wie eingangs beschrieben, zum symmetrischen 3-Phasensystem ein Nullsystem hinzu, dessen Quelle im Fußpunkt des Erdschlusses gedacht werden kann.

In Fig. 2 ist ein Ersatzschaltbild dieses Nullsystems dargestellt. Die Erdschlußlöschspule 5 weist einen ohmschen Verlustwiderstand 10 auf. Der ohmsche Leitungswiderstand zwischen dem Fußpunkt 7 des Erdschlusses und der Erdschlußlöschspule 5 ist mit 11, der ohmsche Leitungswiderstand zwischen dem Fußpunkt 7 des Erdschlusses und der resultierenden Leiter-Erd-Kapazität 13 der nicht erdschlußbehafteten Phasenleiter R, S mit 12 bezeichnet. Der Leiter-Erd-Kapazität 13 liegt ein Ableitwiderstand 14 parallel. Die »gedachte« Nullsystem-Spannungsquelle 15 speist den aus den Zweigen 11—5—10—6 und 12—13—14—6 bestehenden Parallelschwingkreis am Verbindungspunkt der Leitungswiderstände 11, 12. Bei richtiger Resonanzabstimmung des so gebildeten Parallelschwingkreises auf die Netzfrequenz durch Einstellung der Erdschlußlöschspule 5 wird, wie eingangs bereits erwähnt, im Fußpunkt 7 des Erdschlusses der induktive Spulenstrom vom kapazitiven Leiter-Erd-Strom gerade kompensiert, und es fließt nur noch der Erdschluß-Reststrom über den Fußpunkt. Die Flußrichtung des Reststroms kann am Zeigerausschlag von im Netz eingebauten Richtungsrelais festgestellt werden. Die festgestellten Richtungen zeigen von allen Seiten des Netzes aus auf den Fußpunkt des Erdschlusses hin.

In Fig. 3 ist ein einpoliges Gleichstromsimulationsmodell für eine Erdschlußrichtungsanzeige in einem vermaschten, erdschlußkompensierten Netz dargestellt. Die einzelnen, zwischen dem Modell-Fußpunkt 7 des Erdschlusses und dem ohmschen Modell-Verlustwiderstand 10 der Erdschlußlöschspule liegenden Leitungen der erdschlußbehafteten Modell-Phase T, jeweils repräsentiert durch ihre ohmschen Modell-Leitungswiderstände, sind mit den Bezugsziffern 16 bis 23 bezeichnet. Da im vorliegenden Beispiel aufgrund der im Netz erhaltenen unvollkommenen Richtungsangaben des Reststroms vermutet wird, daß der Erdschluß in der Masche mit dem Modell-Leitungswiderstand 23 auftritt, wird eine mit Erde verbundene Modell-Gleichspannungsquelle 15 an den ohmschen Modell-Leitungswiderstand 23 angelegt. Am einpoligen Gleichstromsimulationsmodell wird in der vermuteten erdschlußbehafteten Masche mit dem Modell-Leitungswiderstand 23 ein Erdschluß simuliert, und die durch die Simulation erhaltenen Richtungsangaben werden mit den echt erhaltenen Richtungsangaben verglichen. Die Richtungen des fließenden Modell-Erdschluß-Reststroms in den einzelnen Maschen sind dabei durch +/ −-Kennzeichnung bzw. durch die Richtung des Spannungsabfalls an den einzelnen Modell-Leitungswiderständen 16 bis 23 gekennzeichnet.

Die Empfindlichkeiten der Richtungsanzeigen im Gleichstromsimulationsmodell müssen dabei denen im Netz entsprechen, und die Erdschlußenergie wird im Gleichstromsimulationsmodell entsprechend der Höhe der gemessenen Verlagerungsspannung und des Erdschlußlöschspulenstroms eingestellt.

Sind dann die echt erhaltenen Richtungsangaben mit den simulierten Richtungsangaben identisch, so wird die erdschlußverdächtige Masche im Netz freigeschaltet, d. h., die Freischaltung erfolgt gezielt dort, wo im Gleichstromsimulationsmodell der simulierte Erdschluß auf Verdacht eingebaut wurde. Dabei kann der Vergleich der echten mit den simulierten Richtungsangaben mittels eines Digitalrechners vorgenommen werden, wobei dann das Gleichstromsimulationsmodell in Form eines Netzmodells in diesem Rechner abgespeichert ist.

Bei Verwendung von wattmetrischen Erdschlußrichtungsrelais im Netz kann das Netzmodell die Form eines oben beschriebenen einpoligen Gleichstromnetzmodells haben, da es nur die Richtung des Erdschluß-Reststroms zu simulieren gilt (das Nullsystem ist auf Resonanz mit der Netzfrequenz abgestimmt). Das gleiche gilt für Erdschluß-Wischerrelais, da die Umladeenergie bei Eintritt des Erdschlusses die gleiche Richtung nimmt.

Der Leitungswiderstand der anderen beiden Phasenleiter R, S und deren ohmschen Beläge können vernachlässigt werden, da die Wirkkomponente des Ableitungsstroms im Netz sehr viel geringer ist als der Erdschluß-Reststrom durch die Löschspule. Das dermaßen simulierte Nullsystem wird gespeist von einer Gleichspannungsquelle im Fußpunkt des angenommenen Erdschlusses. Der Ort des Erdschlusses bestimmt dann die Polarität des Gleichspannungsabfalls über den Modell-Leitungswiderständen der Leitungen.

**Patentansprüche**

1. Verfahren zur Lokalisierung eines einpoligen Erdschlusses in einem vermaschten, erdschlußkompensierten Drehstromnetz,

a) bei dem ein allen Phasenleitern (R, S, T) des Drehstromnetzes gemeinsamer Potential-Nullpunkt (4) über eine Erdschlußlöschspule (5) geerdet (6) wird,

b) bei dem die Energieflußrichtung des bei Erdschluß fließenden Erdschluß-Reststroms mit Hilfe von im Drehstromnetz eingebauten wattmetrischen Richtungsrelais oder

c) die Richtung der Umladeenergie bei Eintritt des Erdschlusses im Drehstromnetz mit Hilfe von im Drehstromnetz eingebauten Erdschluß-Wischerrelais detektiert wird,

d) bei dem das vermaschte Drehstromnetz in einem Netzsimulationsmodell nachgebildet wird und

e) die Energieflußrichtungen im Netzsimulationsmodell mit den durch die Richtungsrelais bzw. Erdschluß-Wischerrelais detektierten Energieflußrichtungen im Drehstromnetz verglichen werden,
dadurch gekennzeichnet,

f) daß die Leitungswiderstände des vermaschten Drehstromnetzes durch ohmsche Modell-Leitungswiderstände (16 bis 23) nachgebildet werden und daß die Erdschlußlöschspule (5) durch einen ohmschen Modell-Verlustwiderstand (10) nachgebildet wird,

g) daß den Modell-Leitungswiderständen (16 bis 23) Modell-Energieflußrichtungsanzeigeeinrichtungen zugeordnet werden,

h) daß in dem Netzsimulationsmodell eine Modell-Spannungsquelle (15) an den Modell-Leitungswiderstand (16 bis 23) angeschlossen wird, welcher am mutmaßlichen Fußpunkt (7) des Erdschlusses liegt, wobei diese Modell-Spannungsquelle (15) mit dem Modell-Verlustwiderstand (10) in Wirkverbindung gebracht wird.

2. Verfahren nach Anspruch 1, dadurch gekennzeichnet,

a) daß die Modell-Spannungsquelle (15) eine Gleichspannungsquelle ist und

b) daß die Energieflußrichtungen im Netzsimulationsmodell aus den Polaritäten der Gleichspannungsabfälle über den Modell-Leitungswiderständen (16 bis 23) bestimmt wird.

3. Verfahren nach Anspruch 1 oder 2, dadurch gekennzeichnet,

a) daß der Vergleich der Energieflußrichtungen im Netzsimulationsmodell mit den detektierten Energieflußrichtungen im Drehstromnetz mittels eines Digitalrechners vorgenommen wird und

b) daß das Netzsimulationsmodell in diesem Digitalrechner abgespeichert ist.

4. Erdschlußrelaisschaltung zur Lokalisierung eines einpoligen Erdschlusses in einem vermaschten, erdschlußkompensierten Drehstromnetz zur Durchführung des Verfahrens nach einem der vorhergehenden Ansprüche,

a) mit einer geerdeten Erdschlußlöschspule (5), die an einen allen Phasenleitern (R, S, T) des Drehstromnetzes gemeinsamen Potential-Nullpunkt (4) angeschlossen ist,

b) mit im Drehstromnetz eingebauten wattmetrischen Richtungsrelais zur Bestimmung der Energie-Richtung des bei Erdschluß fließenden Erdschluß-Reststroms oder

c) mit im Drehstromnetz eingebauten Erdschluß-Wischerrelais zur Bestimmung der Richtung der Umladeenergie bei Eintritt eines Erdschlusses,

d) wobei ein Netzsimulationsmodell vorgesehen ist, das eine Nachbildung des auf einen einpoligen Erdschluß zu überwachenden Drehstromnetzes darstellt, zum Vergleich der Energieflußrichtungen im Netzsimulationsmodell mit den durch die Richtungsrelais bzw. Erdschluß-Wischerrelais detektierten Energieflußrichtungen im Drehstromnetz, dadurch gekennzeichnet,

e) daß in dem Netzsimulationsmodell die Leitungswiderstände des vermaschten Drehstromnetzes (R, S, T) durch ohmsche Modell-Leitungswiderstände (16 bis 23) nachgebildet sind und daß die Erdschlußlöschspule (5) durch einen ohmschen Modell-Verlustwiderstand (10) nachgebildet ist,

f) daß diese Modell-Leitungswiderstände mit Modell-Energieflußrichtungsanzeigeeinrichtungen in Wirkverbindung stehen, zur Bestimmung der Energieflußrichtung durch die Modell-Leitungswiderstände, und

g) daß in dem Netzsimulationsmodell eine Modell-Spannungsquelle (15) vorgesehen ist, welche wahlweise an jeden der Modell-Leitungswiderstände (16 bis 23) anschließbar ist, wobei der Anschluß in Abhängigkeit von dem mutmaßlichen Fußpunkt (7) des Erdschlusses erfolgt und wobei diese Modell-Spannungsquelle (15) mit dem Modell-Verlustwiderstand (10) in Wirkverbindung steht.

5. Erdschlußrelaisschaltung nach Anspruch 4, dadurch gekennzeichnet, daß die Modell-Spannungsquelle eine Gleichspannungsquelle (15) ist.

6. Erdschlußrelaisschaltung nach Anspruch 4 oder 5, dadurch gekennzeichnet,

a) daß zum Vergleich der Energieflußrichtungen im Netzsimulationsmodell mit den durch die Richtungsrelais bzw. Erdschluß-Wischerrelais detektierten Energieflußrichtungen im Drehstromnetz ein Digitalrechner vorgesehen ist und

b) daß das Netzsimulationsmodell in diesem Digitalrechner abgespeichert ist.

**Claims**

1. Method for locating a single-line-to-earth short in a meshed earth-short-compensated three-phase system,

a) in which method a zero-potential point (4) which is common to all phase conductors (R, S, T) of the three-phase system is earthed (6), via an earth-short arc-suppression coil (5),

b) in which the direction of energy flow of the earth-short leakage current flowing during an earth short is detected with the aid of wattmeter-type directional relays installed in the three-phase system or

c) the direction of the recharging energy with onset of the earth short in the three-phase system is detected with the aid of momentary-contact-type earth-short relays installed in the three-phase system,

d) in which the meshed three-phase system is simulated in a system simulation model and

e) the directions of energy flow in the system simulation model are compared with the directions of energy flow in the three-phase system detected by the directional relays or momentary-contact-type earth-short relays, characterised in

f) that the line resistances of the meshed three-phase system are simulated by resistive model line resistances (16 to 23) and that the earth-short arc-suppression coil (5) is simulated by a resistive model loss resistance (10),

g) that the model line resistances (16 to 23) are associated with model energy flow direction indicating devices,

h) that in the system simulation model a model voltage source (15) is connected to the model line resistance (16 to 23) which resistance is located at the suspected root (7) of the earth short, this model voltage source (15) being effectively connected to the model loss resistance (10).

2. Method according to Claim 1, characterised in

a) that the model voltage source (15) is a direct-voltage source and

b) that the directions of energy flow in the system simulation model are determined from the polarities of the direct-voltage drops across the model line resistances (16 to 23).

3. Method according to Claim 1 or 2, characterised in

a) that the directions of energy flow in the system simulation model are compared with the directions of energy flow detected in the three-phase system by means of a digital computer and

b) that the system simulation model is stored in this digital computer.

4. Earth-short relay circuit for locating a single-line-to-earth short in a meshed, earth-short compensated three-phase system for carrying out the method according to one of the preceding claims,

a) including an earthed earth-short arc-suppression coil (5) which is connected to a zero-potential point (4) which is common to all phase conductors (R, S, T) of the three-phase system,

b) a wattmeter-type directional relay installed in the three-phase system for determining the direction of energy of the earth-short leakage current flowing during a short or

c) a momentary-contact-type earth-short relay installed in the three-phase system, for determining the direction of the recharging energy with onset of an earth short,

d) a system simulation model being provided which presents a simulation of the three-phase system to be monitored for a single-line-to-earth short, for comparing the directions of energy flow in the system simulation model with the directions of energy flow in the three-phase system detected by the directional relays or momentary-contact-type earth-short relays,
characterised in

e)  that in the system simulation model, the line resistances of the meshed three-phase system (R, S, T) are simulated by resistive model line resistances (16 to 23) and that the earth-short arc-suppression coil (5) is simulated by a resistive model loss resistance (10),

f)  that these model line resistances are effectively connected to model energy flow direction indicating devices, for determining the direction of energy flow through the model line resistances, and

g)  that in the system simulation model, a model voltage source (15) is provided which can be optionally connected to each of the model line resistances (16 to 23) the connection being made in dependence on the presumed root (7) of the earth short and this model voltage source (15) being effectively connected to the model loss resistance (10).

5. Earth-short relay circuit according to Claim 4, characterised in that the model voltage source is a direct-voltage source (15).

6. Earth-short relay circuit according to Claim 4 or 5, characterised in

a)  that for comparing the directions of energy flow in the system simulation model with the directions of energy flow in the three-phase system detected by the directional relays or momentary-contact-type earth-short relays a digital computer is provided and

b)  that the system simulation model is stored in this digital computer.

**Revendications**

1. Procédé pour localiser une perte à la terre monopolaire dans un réseau triphasé maillé à compensation des pertes à la terre,

a)  dans lequel un point zéro de potentiel (4) commun à tous les conducteurs de phase (R, S, T) du réseau triphasé est mis à la terre (6) par l'intermédiaire d'une bobine d'extinction de perte à la terre (5),

b)  dans lequel la direction du flux d'énergie du courant résiduel de perte à la terre qui passe en cas de perte à la terre est détectée au moyen d'un relais de direction wattmétrique incorporé dans le réseau triphasé ou

c)  la direction de l'énergie d'inversion de charge lors de l'entrée de la perte à la terre dans le réseau triphasé est détectée à l'aide d'un relais de passage de perte à la terre incorporé dans le réseau triphasé,

d)  dans lequel le réseau triphasé maillé est simulé dans un modèle de simulation de réseau, et

e)  les directions de flux d'énergie dans le modèle de simulation de réseau sont comparées dans le réseau triphasé avec les directions de flux d'énergie détectées par le relais de direction ou le relais de passage de perte à la terre,
caractérisé en ce que,

f)  les résistances de ligne du réseau triphasé maillé sont simulées par des résistances de ligne de modèle ohmique (16 à 23) et la bobine d'extinction de perte à la terre (5) est simulée par une résistance de perte de modèle ohmique (10),

g)  les résistances de ligne de modèle (16 à 23) sont associées à des dispositifs d'affichage de la direction des flux d'énergie de modèle,

h)  dans le modèle de simulation de réseau, une source de tension de modèle (15) est connectée à la résistance de ligne de modèle (16 à 23) qui se situe à la base présumée (7) de la perte à la terre, étant entendu que cette source de tension de modèle (15) est connectée activement à la résistance de perte de modèle (10).

2. Procédé suivant la revendication 1, caractérisé en ce que,

a)  la source de tension de modèle (15) est une source de tension continue, et

b)  les directions de flux d'énergie dans le modèle de simulation de réseau sont déterminées à partir des polarités des chutes de tension continue par l'intermédiaire des résistances de ligne de modèle (16 à 23).

3. Procédé suivant la revendication 1 ou 2, caractérisé en ce que,

a)  la comparaison des directions de flux d'énergie dans le modèle de simulation de réseau avec les directions de flux d'énergie détectées dans le réseau triphasé est effectuée au moyen d'un calculateur numérique et

b)  le modèle de simulation de réseau est stocké dans ce calculateur numérique.

4. Montage de relais de mise à la terre pour localiser une perte à la terre unipolaire dans un réseau triphasé maillé à compensation pour les pertes à la terre, en vue de réaliser le procédé suivant l'une quelconque des revendications précédentes, comportant

a)  une bobine d'extinction de perte à la terre (5) mise à la terre, qui est connectée à un point zéro de potentiel commun à tous les conducteurs de phase (R, S, T) du réseau triphasé,

b)  un relais de direction wattmétrique incorporé dans le réseau triphasé pour déterminer la direction de l'énergie du courant résiduel de perte à la terre qui passe dans le cas
d'une perte à la terre ou

c) un relais de passage de perte à la terre incorporé dans le réseau triphasé pour déterminer la direction de l'énergie d'inversion de
charge lors de l'entrée d'une perte à la terre,

d) étant entendu qu'un modèle de simulation
de réseau est prévu et représente une simulation du réseau triphasé à surveiller à propos d'une perte à la terre monopolaire, pour
comparer les directions des flux d'énergie
dans le modèle de simulation de réseau
avec les directions de flux d'énergie détectées dans le réseau triphasé par le relais de
direction ou le relais de passage de perte à
la terre,

caractérisé en ce que,

e) dans le modèle de simulation de réseau, les
résistances de ligne du réseau triphasé
maillé (R, S, T) sont simulées par des résistances de ligne de modèle ohmique (16 à 23)
et la bobine d'extinction de perte à la terre
(5) est simulée par une résistance de perte
de modèle ohmique (10),

f) ces résistances de ligne de modèle sont
connectées activement à des dispositifs indicateurs de direction de flux d'énergie de
modèle pour déterminer la direction des flux
d'énergie passant par les résistances de
ligne de modèle, et

g) dans le modèle de simulation de réseau, une
source de tension de modèle (15) est prévue
et peut être connectée sélectivement à chacune des résistances de ligne de modèle (16
à 23), étant entendu que la connexion s'effectue en fonction de la base présumée (7)
de la perte à la terre et que cette source de
tension de modèle (15) est connectée activement à la résistance de perte de modèle
(10).

5. Montage de relais de mise à la terre suivant
la revendication 4, caractérisé en ce que la
source de tension de modèle est une source de
tension continue (15).

6. Montage de relais de mise à la terre suivant
la revendication 4 ou 5, caractérisé en ce que,

a) pour comparer les directions de flux d'énergie dans le modèle de simulation de réseau
avec les directions de flux d'énergie détectées par le relais de direction ou le relais de
passage de perte à la terre, un calculateur
numérique est prévu dans le réseau triphasé, et

b) le modèle de simulation de réseau est enregistré dans ce calculateur numérique.

Fig. 1

Fig. 2

Fig. 3